# EUROPÄISCHE PATENTSCHRIFT

(11) **EP 4 129 958 B1**
(45) Veröffentlichungstag und Bekanntmachung des Hinweises auf die Patenterteilung: **31.01.2024**
(21) Anmeldenummer: 21189473.8
(22) Anmeldetag: 03.08.2021
(51) Int. Cl.: C04B 41/89, C30B 25/02

(54) **VERFAHREN ZUR HERSTELLUNG VON BESCHICHTETEN SUBSTRATEN SOWIE BESCHICHTETES SUBSTRAT UND DESSEN VERWENDUNG**
METHOD FOR PRODUCING COATED SUBSTRATES AND COATED SUBSTRATE AND USE THEREOF
PROCÉDÉ DE FABRICATION DE SUBSTRATS REVÊTUS, AINSI QUE SUBSTRAT REVÊTU ET SON UTILISATION

(43) Veröffentlichungstag der Anmeldung: 08.02.2023
(73) Patentinhaber: Fraunhofer-Gesellschaft zur Förderung der angewandten Forschung e.V., 80686 München (DE)
(72) Erfinder: SCHUCK, Kevin, 91058 Erlangen (DE); STURM, Felix, 91058 Erlangen (DE); REIMANN, Dr.-Ing. Christian, 91058 Erlangen (DE)
(74) Vertreter: Pfenning, Meinig & Partner mbB

(56) Entgegenhaltungen:
- WO-A2-2019/154690
- US-A1- 2015 175 487
- US-A1- 2015 291 805
- US-A1- 2021 154 976

## Beschreibung

Die vorliegende Erfindung betrifft ein Verfahren zur Herstellung von beschichteten Substraten. Im Verfahren wird zunächst mindestens ein Bereich einer Oberfläche eines porösen Substrats mit mindestens einer Oberflächenversiegelungsschicht versehen wird. Dann wird mindestens eine wässrige Suspension auf der mindestens einen Oberflächenversiegelungsschicht aufgebracht, wobei die mindestens eine wässrige Suspension mindestens ein Refraktärmetallcarbid und Wasser enthält. Danach wird das Substrat einem Sinterprozess unterzogen. Die vorliegende Erfindung betrifft ferner ein beschichtetes Substrat, welches mit dem erfindungsgemäßen Verfahren hergestellt oder herstellbar sein kann, sowie die Verwendung eines solchen beschichteten Substrats.

Refraktärmetallcarbide wie beispielsweise Tantalcarbid (TaC) zeichnen sich im Allgemeinen durch ihre hohe mechanische, chemische und thermische Beständigkeit aus. Der Einsatz dieser Werkstoffe fokussiert sich v.a. auf Hochtemperaturanwendungen, z.B. in der Halbleiterkristallzüchtung, in denen stark korrosive und aggressive Spezies vorhanden sind und damit die Einsatzfähigkeit des bestehenden Bauteils (z.B. aus Graphit) eingeschränkt bzw. dessen Lebensdauer deutlich reduziert wird. Da es sich als schwierig gestaltet, mit Hilfe der aus der Literatur beschriebenen Prozesse zum Heißpressen ein bewährtes Volumenbauteil aus Refraktärmetallcarbiden kostengünstig und in komplexer Geometrie herzustellen, wird bevorzugt auf Beschichtungen zurückgegriffen. Die Herstellung von keramischen Schichten über das Heißpressen ist verfahrensbedingt nicht möglich. Beschichtungen werden beispielsweise über das CVD-Verfahren erzeugt. Dabei werden über die Gasphase dichte Schichten von wenigen Mikrometern auf ein Substrat abgeschieden. Ein Beispiel dazu wären TaC-Beschichtungen im Einlagenaufbau. Das kostenintensive Verfahren verwehrt allerdings, dass beschichtete Bauteile mit beliebigen Geometrien und Größen mit beliebiger Schichtdicke realisiert werden können. Um eine größere Flexibilität in diesen Bereichen zu gewährleisten, gibt es die Möglichkeit, die Schichten über ein nasskeramisches Verfahren (Tauchen, Pinseln oder Versprühen) auf das Substrat aufzutragen. Dies kann beispielsweise über eine Suspension auf Basis von organischen Lösungsmitteln erreicht werden (siehe z.B. US 2013/0061800 A1). Für die Erzeugung der gewünschten Schutzschichteigenschaften wird dem Auftragungsprozess über eine Ausgangssuspension ein Sinterprozess nachgeschaltet.

Neben der Erzeugung einer mechanisch stabilen Beschichtung durch den abschließenden Sinterprozess (hohe Abrieb- und Haftfestigkeit) wird gleichzeitig ein hoher Verdichtungsgrad gefordert, um das Substrat optimal vor korrosiven Medien in der Hochtemperaturanwendung zu schützen. Zusätzlich zu der Forderung eines hohen Verdichtungsgrads wird ebenso verlangt, dass die Ausbildung von Rissen in der Beschichtung nach dem Sintervorgang auf ein Minimum reduziert ist, um schlussendlich die Schutzschichteigenschaften der Refraktärmetallcarbid-Beschichtung zu gewährleisten und das Grundsubstrat maximal vor korrosiven Medien in der Hochtemperaturanwendung zu schützen. Risse können während des Sinterprozesses z.B. beim Verdichtungs- bzw. Schrumpfungsvorgang oder auch beim Abkühlen entstehen. Die Schrumpfungsrisse können dadurch vermieden werden, dass die aufgetragenen Grünschichten einen gleichmäßigen bzw. homogen dicken Verlauf zeigen und somit eine gleichmäßige Verdichtung stattfinden kann. Bei Inhomogenitäten im Schichtverlauf (wie z.B. Depressionen) bilden sich leicht Schrumpfungsrisse, die sich im weiteren Verlauf des Sinterprozesses oder später auch unter Einsatzbedingungen vertikal bzw. lateral ausbreiten können. Die Rissbildung beim Abkühlen ist auf den Abbau von zu hohen thermischen Zugspannungen zurückzuführen, die durch den meist großen Unterschied im thermischen Ausdehnungskoeffizienten zwischen der Refraktärmetallcarbid-Beschichtung und dem Grundsubstrat induziert werden.

Der Erhalt eines homogenen Schichtverlaufs wird bei der Suspensions-basierten Beschichtung von porösen Substraten, wie z.B. CFC-Substraten, mit Refraktärmetallcarbid-Beschichtungen jedoch durch das starke Infiltrationsverhalten der porösen Substrate und die daraus resultierende Infiltration der Poren durch die Suspension erschwert und führt so zu einem inhomogenen Verlauf der Refraktärmetallcarbid-Beschichtungen.

Die US 2021/154976 A1 ist gerichtet auf ein hitzebeständiges Element umfassend ein Basiselement, das aus einem isotropen Graphit besteht, und ein Film mit einer einzelnen Schicht oder mehreren Schichten, die auf der gesamten oder einer Teilfläche des Basiselements ausgebildet sind.

Ausgehend hiervon war es die Aufgabe der vorliegenden Erfindung ein Verfahren zur Herstellung von beschichteten Substraten anzugeben, mit dem Substrate mit einer möglichst homogen verlaufenden und möglichst rissfreien Refraktärmetallcarbid-Beschichtung erhalten werden können. Zudem war es die Aufgabe der vorliegenden Erfindung beschichte Substrate bereitzustellen, die eine möglichst homogen verlaufende und möglichst rissfreie Refraktärmetallcarbid-Beschichtung aufweisen.

Diese Aufgabe wird bezüglich eines Verfahrens zur Herstellung von beschichteten Substraten mit den Merkmalen des Patentanspruchs 1 und bezüglich eines beschichteten Substrats mit den Merkmalen des Patentanspruchs 8 gelöst. In Patentanspruch 11 werden Verwendungsmöglichkeiten des erfindungsgemäßen beschichteten Substrats angegeben. Die abhängigen Patentansprüche stellen vorteilhafte Weiterbildungen dar.

Erfindungsgemäß wird somit ein Verfahren zur Herstellung von beschichteten Substraten angegeben, bei welchem
a) mindestens ein Bereich einer Oberfläche eines porösen Substrats mit mindestens einer Oberflächenversiegelungsschicht versehen wird,
b) mindestens eine wässrige Suspension auf der mindestens einen Oberflächenversiegelungsschicht aufgebracht wird, wobei die mindestens eine wässrige Suspension mindestens ein Refraktärmetallcarbid und Wasser enthält, und
c) das Substrat nach Schritt b) einem Sinterprozess unterzogen wird,

wobei das poröse Substrat ein Material enthält oder aus diesem besteht, welches ausgewählt ist aus der Gruppe bestehend aus Graphit, C/SiC-Faserverbundwerkstoffen, SiC/SiC-Faserverbundwerkstoffen, carbidischen Keramiken, nitridischen Keramiken, oxidischen Keramiken, und Mischungen hiervon, und
wobei die mindestens eine Oberflächenversiegelungsschicht ausgewählt ist aus der Gruppe bestehend aus pyrolytischen Kohlenstoffschichten, Siliciumschichten, Zirconiumboridschichten, Tantalnitridschichten, Siliciumcarbidschichten, Siliciumnitridschichten und Kombinationen hiervon.

In Schritt a) des erfindungsgemäßen Verfahrens wird zunächst mindestens ein Bereich einer Oberfläche eines porösen Substrats mit mindestens einer Oberflächenversiegelungsschicht versehen. Hierbei können ein Bereich (bzw. ein Teilbereich) der Oberfläche des porösen Substrats oder mehrere Bereiche (bzw. mehrere Teilbereiche) der Oberfläche des porösen Substrats oder die gesamte Oberfläche des porösen Substrats mit der mindestens einen Oberflächenversiegelungsschicht versehen werden. Der mindestens eine Bereich der Oberfläche des porösen Substrats kann mit einer Oberflächenversiegelungsschicht oder mit mehreren Oberflächenversiegelungsschichten versehen werden.

Bei dem porösen Substrat kann es sich vorzugsweise um ein Kohlenstoff-Substrat, besonders bevorzugt um ein Graphit-Substrat, ganz besonders bevorzugt um ein iso-Graphit-Substrat, handeln. Unter iso-Graphit wird dabei Graphit verstanden, der nach dem Verfahren des isostatischen Pressens hergestellt wurde. Beispielsweise kann das poröse Substrat ein Tiegel, vorzugsweise ein Kohlenstoff-Tiegel, besonders bevorzugt ein Graphit-Tiegel, ganz besonders bevorzugt ein iso-Graphit-Tiegel, sein.

Vorzugsweise weisen die Poren des porösen Substrat eine mittlere Porengröße im Bereich von 0,5 µm bis 5 µm (vorzugsweise an der Oberfläche) auf. Die mittlere Porengröße (vorzugsweise an der Oberfläche) kann beispielsweise bestimmt werden mittels Quecksilberintrusion (DIN 66133:1993-06).

Vorzugsweise weisen die Poren des porösen Substrat einen mittlere Poreneingangsdurchmesser im Bereich von 0,1 µm bis 5 µm auf. Der mittlere Poreneingangsdurchmesser kann beispielsweise bestimmt werden mittels Quecksilberporosimetrie (DIN 15901-1:2019-03).

Vorzugsweise weist das poröse Substrat eine offene Porosität im Bereich von 5 % bis 20 % auf. Die offene Porosität kann beispielsweise bestimmt werden mittels Quecksilberintrusion (DIN 66133:1993-06).

In Schritt b) des erfindungsgemäßen Verfahrens wird mindestens eine wässrige Suspension auf der mindestens einen (in Schritt a) aufgebrachten) Oberflächenversiegelungsschicht aufgebracht. Die mindestens eine wässrige Suspension kann auf einem Teilbereich oder mehreren Teilbereichen der mindestens einen Oberflächenversiegelungsschicht oder auf der gesamten mindestens einen Oberflächenversiegelungsschicht aufgebracht werden. Die mindestens eine wässrige Suspension kann schichtförmig auf der mindestens einen Oberflächenversiegelungsschicht aufgebracht werden. Die so aufgebrachte Schicht (bzw. die so aufgebrachten Schichten) der mindestens einen wässrigen Suspension kann (bzw. können) als Grünschicht (bzw. Grünschichten) bezeichnet werden. In Schritt b) wird mindestens eine Schicht der mindestens einen wässrigen Suspension auf der mindestens einen Oberflächenversiegelungsschicht aufgebracht. Erfindungsgemäß enthält die mindestens eine wässrige Suspension mindestens ein Refraktärmetallcarbid und Wasser. Die mindestens eine wässrige Suspension kann auch aus mindestens einem Refraktärmetallcarbid und Wasser bestehen. Vorzugsweise handelt es sich bei dem mindestens einen Refraktärmetallcarbid um Tantalcarbid.

In Schritt c) des erfindungsgemäßen Verfahrens wird das Substrat nach Schritt b) einem Sinterprozess unterzogen. Durch den Sinterprozess kann mindestens eine das mindestens eine Refraktärmetallcarbid enthaltende Schutzschicht aus der mindestens einen (in Schritt b) aufgebrachten) wässrigen Suspension hergestellt werden. Mit anderen Worten kann die mindestens eine (in Schritt b) aufgebrachte) wässrige Suspension durch den Sinterprozess in eine Schutzschicht umgewandelt werden, die das mindestens eine Refraktärmetallcarbid enthält.

Das erfindungsgemäße Verfahren ermöglicht die Herstellung von Refraktärmetallcarbid-basierten Schichten auf Substraten, die als Hochtemperatur- und Verschleißschutzschichten bzw. Verschleißschutzschichtsysteme dienen können.

Beim erfindungsgemäßen Verfahren handelt es sich um ein nasskeramisches Verfahren zur Herstellung von Refraktärmetallcarbid-basierten Beschichtungen auf Substraten. Im Gegensatz zu über CVD- oder PVD-Verfahren hergestellten Schichten, zeigen die über nasskeramische Verfahren hergestellten Schichten eine isotrope Textur mit zufälliger Korngrößenorientierung, was zu einer verminderten Anfälligkeit für Rissbildung und zu einer Erhöhung des Diffusionswegs für substratschädigende Spezies führt. Aufgrund dessen weisen die erfindungsgemäß hergestellten beschichteten Substrate im Vergleich zu über CVD- oder PVD-Verfahren hergestellten beschichteten Substraten einen verbesserten Schutz gegenüber in Hochtemperaturanwendungen verwendeten aggressiven Substanzen auf. Zudem ist das erfindungsgemäße nasskeramische Verfahren kostengünstiger als CVD- oder PVD-Verfahren und bietet zudem mehr Flexibilität bei den Geometrien und Größen der herstellbaren beschichteten Bauteile sowie der Schichtdicken der aufgebrachten Beschichtungen bzw. Schichten.

Ferner basiert das erfindungsgemäße Verfahren zur Herstellung beschichteter Substrate auf der Verwendung einer wässrigen Suspension. Gegenüber der Verwendung organischer Suspensionen hat die Verwendung wässriger Suspensionen diverse Vorteile. So sind wässrige Suspensionen im Gegensatz zu organischen Suspensionen kostengünstig, aus ökologischer und gesundheitlicher Sicht unbedenklich und bringen auch nicht das sicherheitstechnische Problem leicht entflammbarer Sprühnebel mit sich. Außerdem kann bei der Verwendung wässriger Suspensionen auf eine Pyrolyse zur Entfernung organischer Lösemittel verzichtet werden, die zu einem unerwünschten Eintrag von Fremdstoffen in die Beschichtung führen kann. Weiterhin ist bei der Verwendung wässriger Suspensionen im Gegensatz zur Verwendung der bekannten organischen Suspensionen ein kontrollierter Auftrag der Suspension möglich. So ist insbesondere beim Sprühauftrag der bekannten organischen Suspensionen kein kontrollierter Auftrag möglich, da die Suspensionseigenschaften während dieses Vorgangs durch Verdampfung des Lösemittels schwanken können, so dass über die Zeit keine homogenen Schichten erhalten werden können.

Aufgrund des Sinterprozesses handelt es sich bei der im erfindungsgemäßen Verfahren erhaltenen Schutzschicht um eine mechanisch stabile Beschichtung mit hoher Abrieb- und Haftfestigkeit. Zudem wird durch den Sinterprozess ein höherer Verdichtungsgrad gegenüber der Ausgangsdichte nach dem Auftragen (Gründichte) erzielt.

Die mindestens eine Oberflächenversiegelungsschicht stellt eine Zwischenschicht zwischen dem porösen Substrat und der mindestens einen Schutzschicht, die in Schritt c) erhalten werden kann, dar. Durch die mindestens eine Oberflächenversiegelungsschicht können die Poreneingänge (der Poren des porösen Substrats), die sich auf dem mindestens einen Bereich der Oberfläche des porösen Substrats befinden, im Wesentlichen vollständig oder zumindest nahezu vollständig verschlossen werden. Auf diese Weise wird die Oberfläche des mindestens einen Bereichs quasi versiegelt (bzw. quasi nahezu versiegelt). Bei der mindestens einen Oberflächenversiegelungsschicht kann es sich somit um mindestens eine (im Wesentlichen) geschlossene Oberflächenversiegelungsschicht handeln. Ob die Poreneingänge im Wesentlichen vollständig oder zumindest nahezu vollständig verschlossen sind, kann durch Bestimmung der Gasdurchlässigkeit des porösen Substrats in dem mit der Oberflächenversiegelungsschicht versehenen Bereich ermittelt werden, wobei die Gasdurchlässigkeit z.B. mittels druckabhängiger Durchströmungsmessung nach DIN EN 993-4:1995-04 bestimmt werden kann. Beträgt die (z.B. mittels druckabhängiger Durchströmungsmessung nach DIN EN 993-4:1995-04) gemessene Gasdurchlässigkeit 0 m², sind die Poreneingänge im Wesentlichen vollständig verschlossen. Der Begriff "im Wesentlichen" bedeutet hierbei, dass eine minimale Durchlässigkeit der Poreneingänge vorhanden sein kann, die jedoch (z.B. mittels druckabhängiger Durchströmungsmessung nach DIN EN 993-4:1995-04) nicht messbar ist. Beträgt die (z.B. mittels druckabhängiger Durchströmungsmessung nach DIN EN 993-4:1995-04) gemessene Gasdurchlässigkeit nahezu 0 m², sind die Poreneingänge nahezu vollständig verschlossen. Beispielsweise sind die Poreneingänge dann zumindest nahezu vollständig verschlossen, wenn die (z.B. mittels druckabhängiger Durchströmungsmessung nach DIN EN 993-4:1995-04) gemessene Gasdurchlässigkeit des porösen Substrats in dem mit der Oberflächenversiegelungsschicht versehenen Bereich maximal 1E-16m² beträgt oder die (z.B. mittels druckabhängiger Durchströmungsmessung nach DIN EN 993-4:1995-04) gemessene Gasdurchlässigkeit des porösen Substrats in dem mit der Oberflächenversiegelungsschicht versehenen Bereich maximal 10 % der (z.B. mittels druckabhängiger Durchströmungsmessung nach DIN EN 993-4:1995-04) gemessenen Gasdurchlässigkeit des porösen Substrats ohne Oberflächenversiegelungsschicht beträgt. Mit anderen Worten können die Poreneingänge, die sich auf dem mindestens einen Bereich der Oberfläche des porösen Substrats befinden, durch die Oberflächenversiegelungsschicht so (nahezu vollständig) verschlossen werden, dass die Gasdurchlässigkeit des porösen Substrats in dem mit der Oberflächenversiegelungsschicht versehenen Bereich maximal 1E-16 m² beträgt oder die Gasdurchlässigkeit des porösen Substrats in dem mit der Oberflächenversiegelungsschicht versehenen Bereich maximal 10 % der Gasdurchlässigkeit des porösen Substrats ohne Oberflächenversiegelungsschicht beträgt. Ganz besonders bevorzugt beträgt die Gasdurchlässigkeit des porösen Substrats in dem mit der Oberflächenversiegelungsschicht versehenen Bereich maximal 0 m².

Da die Poreneingänge (der Poren des porösen Substrats), die sich auf dem mindestens einen Bereich der Oberfläche des porösen Substrats befinden, vollständig oder zumindest nahezu vollständig durch die Oberflächenversiegelungsschicht verschlossen werden, kann die in Schritt b) aufgetragene mindestens eine wässrige Suspension nicht oder nur sehr geringfügig in die Poren des porösen Substrats gelangen. Dadurch, dass die mindestens eine wässrige Suspension nicht direkt auf dem porösen Substrat sondern stattdessen auf der Oberflächenversiegelungsschicht aufgetragen wird, kann somit verhindert oder zumindest im Wesentlichen verhindert werden, dass die mindestens eine wässrige Suspension beim Aufbringen in Schritt b) in die Poren des porösen Substrats gelangt.

Ohne Verwendung einer Oberflächenversiegelungsschicht würden beim Aufbringen der wässrigen Suspension auf das poröse Substrat erhebliche Mengen der wässrigen Suspension in die Poren des porösen Substrats gelangen, was zu Inhomogenitäten innerhalb der Schicht führen würde. Bei solchen Inhomogenitäten im Schichtverlauf (wie z.B. Depressionen) bilden sich leicht Schrumpfungsrisse, die sich im weiteren Verlauf des Sinterprozesses oder später auch unter Einsatzbedingungen vertikal bzw. lateral ausbreiten können. Die Rissbildung beim Abkühlen ist auf den Abbau von zu hohen thermischen Zugspannungen zurückzuführen, die durch den meist großen Unterschied im thermischen Ausdehnungskoeffizienten zwischen der Refraktärmetallcarbid-Beschichtung und dem (z.B. Kohlenstoff-basierten) Grundsubstrat induziert werden.

Durch die im erfindungsgemäßen Verfahren verwendete mindestens eine Oberflächenversiegelungsschicht kann nun eine sehr homogene (bzw. gleichmäßige) Beschichtung erhalten werden, da durch die mindestens einen Oberflächenversiegelungsschicht ein Eindringen der wässrigen Suspension in die Poren des porösen Substrats verhindert oder zumindest im Wesentlichen verhindert werden kann. Durch den sehr homogenen (bzw. gleichmäßigen) Verlauf der Schicht können Schrumpfungsrisse innerhalb der Schutzschicht vermieden werden. Dies ist auch deshalb der Fall, da durch den gleichmäßigen bzw. homogenen Schichtverlauf eine gleichmäßige Verdichtung stattfinden kann. Je weniger Schrumpfungsrisse in der erhaltenen Schutzschicht vorhanden sind, desto besser ist das Substrat durch die Schutzschicht (z.B. vor korrosiven Medien in Hochtemperaturanwendungen) geschützt. Durch die erfindungsgemäß eingesetzte Oberflächenversiegelungsschicht kann somit eine sehr homogene und nur geringfügig rissbehaftete (oder sogar rissfreie) Refraktärmetallcarbid-Schutzschicht erhalten werden, die das Substrat effektiv vor Fremdeinflüssen (wie z.B. vor korrosiven Medien in Hochtemperaturanwendungen) schützen kann.

Vorzugsweise ist der thermische Ausdehnungskoeffizient (CTE) der mindestens eine Oberflächenversiegelungsschicht an den thermischen Ausdehnungskoeffizienten des porösen Substrats und/oder an den thermischen Ausdehnungskoeffizienten der mindestens einen Schutzschicht angepasst.

Eine solche Anpassung kann beispielsweise durch Auswahl eines Materials, das einerseits Hochtemperaturbeständig ist und gleichzeitig einen CTE aufweist, der zwischen der Schutzschicht und dem Substrat liegt, sowie Auftragung der Anpassungsschichten über diverse Beschichtungsverfahren z.B. über die Gasphase oder über einen Sprüh-Sinter-Prozess, erfolgen. Dadurch, dass der thermische Ausdehnungskoeffizient (CTE) der mindestens eine Oberflächenversiegelungsschicht an den thermischen Ausdehnungskoeffizienten des porösen Substrats und/oder an den thermischen Ausdehnungskoeffizienten der mindestens einen Schutzschicht angepasst ist, können CTE-Unterschiede zwischen dem porösen Substrat und der mindestens einen Schutzschicht ausgeglichen werden und in der Folge die thermischen Spannungen bzw. die Ausprägung der thermisch induzierten Risse noch weiter minimiert werden. In Abhängigkeit des CTE-Unterschieds zwischen der Schutzschicht und dem Substrat kann die Oberflächenversiegelungsschicht dahingehend genutzt werden, um einen großen CTE-Unterschied auszugleichen bzw. diesen zu minimieren - vor allem dann, wenn hohe thermisch induzierte Spannungen dafür sorgen, dass es zu starker Rissbildung oder sogar zur Delamination nach dem Sintern kommt und dadurch die Schutzschichteigenschaften nicht sichergestellt werden.

Erfindungsgemäß wird in Schritt b) mindestens eine Schicht der mindestens einen wässrigen Suspension auf der mindestens einen Oberflächenversiegelungsschicht aufgebracht. Die mindestens eine Schicht wässrigen Suspension kann als mindestens eine Grünschicht bezeichnet werden. Die Grünschicht bzw. die Grünschichten können einen gleichmäßigen bzw. homogen dicken Verlauf zeigen.

Das mit dem erfindungsgemäßen Verfahren herstellbare beschichtete Substrat kann beispielsweise als Gallium-Verdampfer bzw. Teil eines Gallium-Verdampfers in einem zur Züchtung von Galliumnitrid-Halbleiterkristallen verwendbaren VPE-GaN-Reaktor eingesetzt werden, wobei das im erfindungsgemäßen Verfahren erhaltene Schichtsystem dann als Beschichtung des Gallium-Verdampfers fungiert.

Eine bevorzugte Variante des erfindungsgemäßen Verfahrens zeichnet sich dadurch aus, dass
- das poröse Substrat iso-Graphit enthält oder aus diesem besteht, und/oder
- das mindestens eine Refraktärmetallcarbid ausgewählt ist aus der Gruppe bestehend aus Titancarbiden, Zirconiumcarbiden, Hafniumcarbiden, Vanadiumcarbiden, Niobcarbiden, Tantalcarbiden, Chromcarbiden, Molybdäncarbiden, Wolframcarbiden, und Mischungen hiervon.

Ganz besonders bevorzugt handelt es sich beim dem mindestens einen Refraktärmetallcarbid um Tantalcarbid. Tantalcarbid ermöglicht eine besonders gute Schutzwirkung für das poröse Substrat.

Das poröse Substrat kann vorzugsweise ein Material enthalten oder aus diesem bestehen, welches ausgewählt ist aus der Gruppe bestehend aus Graphit, bevorzugt iso-Graphit, carbidischen Keramiken, nitridischen Keramiken, oxidischen Keramiken, und Mischungen hiervon.

Das poröse Substrat kann vorzugsweise ein Material enthalten oder aus diesem bestehen, welches ausgewählt ist aus der Gruppe bestehend aus Graphit, bevorzugt iso-Graphit, C/SiC-Faserverbundwerkstoffen, SiC/SiC-Faserverbundwerkstoffen, und Mischungen hiervon.

Kohlenstoff-basierte Substrate und SiC-basierte Substrate zeigen beim Auftragen einer wässrigen Suspension ein erhöhtes Infiltrationsverhalten. In der Folge ist das erfindungsgemäße Verfahren besonders für solche Substrate geeignet.

Ganz besonders bevorzugt enthält das poröse Substrat Graphit, bevorzugt iso-Graphit, oder besteht daraus.

Gemäß einer weiteren bevorzugten Variante des erfindungsgemäßen Verfahrens liegt das mindestens eine Refraktärmetallcarbid in der mindestens einen wässrigen Suspension partikulär vor, wobei die mittlere Partikelgröße (d50-Wert) der Partikel des mindestens einen Refraktärmetallcarbids im Bereich von 0,2 µm bis 2 µm, bevorzugt von 0,5 µm bis 1,5 µm, liegt. Die mittlere Partikelgröße (d50-Wert) der Partikel des mindestens einen Refraktärmetallcarbids kann beispielsweise bestimmt werden mittels Laserbeugung (DIN 13320:2020-01).

Eine weitere bevorzugte Ausführungsform des erfindungsgemäßen Verfahrens ist dadurch gekennzeichnet, dass die Poreneingänge, die sich auf dem mindestens einen Bereich der Oberfläche des porösen Substrats befinden, durch die Oberflächenversiegelungsschicht so dicht verschlossen werden, dass
- die Gasdurchlässigkeit des porösen Substrats in dem mit der Oberflächenversiegelungsschicht versehenen Bereich maximal 1E-16m², bevorzugt maximal 1E-17m², besonders bevorzugt maximal 5E-17m², ganz besonders bevorzugt 0 m², beträgt, und/oder
- die Gasdurchlässigkeit des porösen Substrats in dem mit der Oberflächenversiegelungsschicht versehenen Bereich maximal 10 %, bevorzugt maximal 1 %, besonders bevorzugt maximal 0,5 %, der Gasdurchlässigkeit des porösen Substrats ohne Oberflächenversiegelungsschicht beträgt.

Die Gasdurchlässigkeit kann z.B. mittels druckabhängiger Durchströmungsmessung nach DIN EN 993-4:1995-04 bestimmt werden.

Eine weitere bevorzugte Variante des erfindungsgemäßen Verfahrens zeichnet sich dadurch aus, dass das poröse Substrat in Schritt a) mit mindestens einer Oberflächenversiegelungsschicht versehen wird, indem
- zumindest ein Teil der Oberfläche des poröse Substrats mit mindestens einem polymerisierbaren Harz imprägniert wird und das Harz anschließend carbonisiert wird, und/oder
- zumindest ein Teil der Oberfläche des porösen Substrats mit mindestens einem Polysilan imprägniert wird und das Polysilan anschließend pyrolysiert wird, und/oder
- die Poren des porösen Substrats mit Silicium infiltriert werden und optional das Silicium zumindest teilweise in Siliciumcarbid umgewandelt wird, und/oder
- mindestens eine Schicht ausgewählt aus der Gruppe bestehend aus Schichten aus pyrolytischem Kohlenstoff, Siliciumcarbidschichten, Siliciumnitridschichten, und Kombinationen hiervon mittels CVD auf dem porösen Substrat abgeschieden wird, und/oder
- mindestens eine Schicht ausgewählt aus der Gruppe bestehend aus Siliciumschichten, Zirconiumboridschichten, Tantalnitridschichten und Kombinationen hiervon mittels eines Sprühprozesses auf dem porösen Substrat abgeschieden wird.

Es gibt verschiedene bevorzugte Möglichkeiten das poröse Substrat in Schritt a) mit der mindestens einen Oberflächenversiegelungsschicht zu versehen.

Beispielsweise kann das poröse Substrat in Schritt a) mit mindestens einer Oberflächenversiegelungsschicht versehen werden, indem zumindest ein Teil der Oberfläche des porösen Substrats mit mindestens einem polymerisierbaren Harz imprägniert wird und das Harz anschließend carbonisiert wird. Hierbei ist es bevorzugt, dass
- das Imprägnieren mit dem mindestens einen polymerisierbaren Harz dadurch erfolgt, dass eine das mindestens eine polymerisierbare Harz enthaltende Lösung auf den zumindest einen Teil der Oberfläche einmal oder mehrmals aufgetragen wird, und/oder
- das mindestens eine polymerisierbare Harz ausgewählt ist aus der Gruppe bestehend aus Polyimiden, Polybenzimidazolen, Bismaleimiden, Polyarylketonen, Polyphenylensulfiden (in Lösung), und Mischungen hiervon, und/oder
- das Carbonisieren durch eine Wärmebehandlung bei einer Temperatur von 20 °C bis 400 °C erfolgt, und/oder
- der thermische Ausdehnungskoeffizient des porösen Substrats kleiner ist als der thermische Ausdehnungskoeffizient der mindestens einen Schutzschicht, wobei der Unterschied zwischen dem thermischen Ausdehnungskoeffizienten des porösen Substrats und dem thermischen Ausdehnungskoeffizienten der mindestens einen Schutzschicht bevorzugt kleiner ist als 1 e⁻⁶/K.

Gemäß einer weiteren bevorzugten Variante kann das poröse Substrat in Schritt a) mit mindestens einer Oberflächenversiegelungsschicht versehen werden, indem zumindest ein Teil der Oberfläche des porösen Substrats mit mindestens einem Polysilan imprägniert wird und das Polysilan anschließend pyrolysiert wird. Hierbei ist es bevorzugt, dass
- das Imprägnieren mit dem mindestens einen Polysilan dadurch erfolgt, dass eine das mindestens eine Polysilan enthaltende Lösung auf den zumindest einen Teil der Oberfläche einmal oder mehrmals aufgetragen wird, und/oder
- das mindestens eine Polysilan ausgewählt ist aus der Gruppe bestehend aus Polycarbosilanen, Polysiloxanen, Polysilazanen, und Mischungen hiervon, und/oder
- die Pyrolyse durch eine Wärmebehandlung bei einer Temperatur von 20 °C bis 1800 °C erfolgt, und/oder
- der thermische Ausdehnungskoeffizient des porösen Substrats kleiner ist als der thermische Ausdehnungskoeffizient der mindestens einen Schutzschicht, wobei der Unterschied zwischen dem thermischen Ausdehnungskoeffizienten des porösen Substrats und dem thermischen Ausdehnungskoeffizienten der mindestens einen Schutzschicht bevorzugt kleiner ist als 1 e⁻⁶/K.

Gemäß einer weiteren bevorzugten Variante kann das poröse Substrat in Schritt a) mit mindestens einer Oberflächenversiegelungsschicht versehen werden, indem die Poren des porösen Substrats mit Silicium infiltriert werden und das Silicium zumindest teilweise in Siliciumcarbid umgewandelt wird. Hierbei ist es bevorzugt, dass
- das Infiltrieren mit Silicium und das zumindest teilweise Umwandeln des Siliciums in Siliciumcarbid dadurch erfolgt, dass eine Silicium enthaltende Suspension auf das poröse Substrat aufgetragen wird und die aufgetragene Suspension einem Sinterprozess bei einer Temperatur größer als 1420 °C unterzogen wird, wobei vorzugsweise der Infiltrationsprozess (d.h. das Infiltrieren mit Silicium) in den Sinterprozess (d.h. dem Sinterprozess bei einer Temperatur größer als 1420 °C) integriert ist, und/oder
- die erhaltene Oberflächenversiegelungsschicht eine Schichtdicke im Bereich von 5 µm bis 300 µm, vorzugsweise 5 µm bis 100 µm, aufweist, und/oder
- das nach einem teilweisen Umwandeln des Siliciums in Siliciumcarbid das nicht umgewandelte Silicium entfernt wird, vorzugsweise durch Schleifen und/oder Fräsen, und/oder
- der thermische Ausdehnungskoeffizient des porösen Substrats kleiner ist als der thermische Ausdehnungskoeffizient der mindestens einen Schutzschicht, wobei der Unterschied zwischen dem thermischen Ausdehnungskoeffizienten des porösen Substrats und dem thermischen Ausdehnungskoeffizienten der mindestens einen Schutzschicht größer ist als 2 e⁻⁶/K.

Gemäß einer weiteren bevorzugten Variante kann das poröse Substrat in Schritt a) mit mindestens einer Oberflächenversiegelungsschicht versehen werden, indem mindestens eine Schicht ausgewählt aus der Gruppe bestehend aus Schichten aus pyrolytischem Kohlenstoff, Siliciumcarbidschichten, Siliciumnitridschichten, und Kombinationen hiervon mittels CVD auf dem porösen Substrat abgeschieden wird. Hierbei ist es bevorzugt, dass das Abscheiden mittels CVD auf dem porösen Substrat dadurch erfolgt, dass reaktive Gasspezies (z.B. CH₃SiCl₃, H₂, etc. für die Herstellung von CVD-SiC) an die Oberfläche des porösen Substrats gelangen und bei thermischer aktivierter Zersetzung an der Oberfläche des porösen Substrats, vorzugsweise bei Temperaturen im Bereich von 800 °C bis 1400 °C, eine (an das poröse Substrat) chemisch bindende Oberflächenversiegelungsschicht ausgebildet wird.

Eine weitere bevorzugte Variante des erfindungsgemäßen Verfahrens ist dadurch gekennzeichnet, dass vor Schritt a) der Unterschied zwischen dem thermischen Ausdehnungskoeffizienten des porösen Substrats und des thermischen Ausdehnungskoeffizienten der mindestens einen Refraktärmetallcarbid-Schicht bestimmt wird und anhand dieses Unterschieds eine passende Methode zum Versehen des porösen Substrat mit mindestens einer Oberflächenversiegelungsschicht in Schritt a) gewählt wird.

Gemäß einer weiteren bevorzugten Variante des erfindungsgemäßen Verfahrens, ist der thermische Ausdehnungskoeffizient des porösen Substrats kleiner als der thermische Ausdehnungskoeffizient der mindestens einen Schutzschicht, wobei der Unterschied zwischen dem thermischen Ausdehnungskoeffizienten des porösen Substrats und dem thermischen Ausdehnungskoeffizienten der mindestens einen Schutzschicht größer ist als 2 e⁻⁶/K oder kleiner ist als 1 e⁻⁶/K.

Eine weitere bevorzugte Variante des erfindungsgemäßen Verfahrens zeichnet sich dadurch aus, dass die mindestens eine wässrige Suspension
- 60 bis 90 Gew.-%, bevorzugt 70 bis 85 Gew.-%, des mindestens einen Refraktärmetallcarbids, bezogen auf das Gesamtgewicht der wässrigen Suspension, enthält, und/oder
- 0,01 bis 0,5 Gew.-% mindestens eines Dispergierungsmittel, bezogen auf das Gesamtgewicht der wässrigen Suspension, enthält, wobei das Dispergierungsmittel vorzugsweise ausgewählt ist aus der Gruppe bestehend aus Ammoniumhydroxid, Polyalkylenglycolether und Mischungen hiervon, und/oder
- 0,01 bis 5 Gew.-% mindestens eines Bindemittels, bezogen auf das Gesamtgewicht der wässrigen Suspension, enthält, wobei das Bindemittel vorzugsweise ausgewählt ist aus der Gruppe bestehend aus Polyvinylalkohol, Polyphenyloxid und Mischungen hiervon, und/oder
- durch Vermischen ihrer Komponenten mithilfe eines Dispergiergeräts hergestellt wird, wobei das Vermischen mithilfe des Dispergiergeräts vorzugsweise unter Verwendung von Mahlkörpern und/oder über einen Zeitraum von mindestens 12 Stunden erfolgt.

Durch Vermischen der Komponenten mithilfe eines Dispergiergeräts unter vorzugsweiser Verwendung von Mahlkörpern und/oder über einen Zeitraum von mindestens 12 Stunden kann eine optimale Durchmischung der wässrigen Suspension erreicht werden, sodass Inhomogenitäten in der Verteilung und somit in der Verdichtung noch besser vermieden werden können. Beispielsweise können beim Vermischen mit dem Dispergiergerät Umdrehungsgeschwindigkeiten bis zu 1m/s verwendet werden.

Die mindestens ein wässrige Suspension kann mindestens ein Bindemittel ausgewählt aus der Gruppe bestehend aus Polyvinylalkoholen, Natriumbiphenyl-2-yloxiden, Polyphenyloxid, und Mischungen hiervon enthalten, wobei das mindestens eine Bindemittel vorzugweise zu einem Anteil von 0,05 bis 1 Gew.-% oder von 0,01 bis 5 Gew.-%, bezogen auf das Gesamtgewicht der wässrigen Suspension, in der mindestens einen wässrigen Suspension enthalten sein kann.

Gemäß einer weiteren bevorzugten Ausführungsvariante kann die mindestens eine wässrige Suspension ein Sinteradditiv enthalten, welches vorzugsweise ausgewählt ist aus der Gruppe bestehend aus Silicium, Zirconiumborid, Refraktärmetallsiliciden sowie Mischungen hiervon. Es hat sich gezeigt, dass diese Sinteradditive aufgrund ihrer Eigenschaften (z.B. Schmelzpunkte, Siedepunkte, etc.) zumindest den gleichen oder sogar einen besseren Effekt auf den Verdichtungsgrad wie die im Stand der Technik als Sinteradditive verwendeten Übergangsmetalle (z.B. Cobalt, Nickel, Eisen, etc.) haben. Es kann somit durch deren Verwendung ein hoher Verdichtungsgrad der gesinterten Schicht erreicht werden, wodurch das Substrat sehr gut vor korrosiven Medien in Hochtemperaturanwendungen geschützt wird. Die genannten Sinteradditive zeichnen sich gegenüber den im Stand der Technik verwendeten Sinteradditiven, wie z.B. Cobalt, zunächst dadurch aus, dass sie sicherheitstechnisch und gesundheitlich unbedenklich sind. Zudem wird durch deren Verwendung und somit die Vermeidung von Übergangsmetallen als Sinteradditive verhindert, dass diese Übergangsmetalle als Verunreinigung in der Schicht erhalten bleiben, was bei einer Verwendung des beschichteten Substrats in Hochtemperaturanwendungen bei der Halbleiterkristallzüchtung schädlich für die dortige Züchtungsatmosphäre wäre.

Gemäß einer weiteren bevorzugten Variante des erfindungsgemäßen Verfahrens erfolgt das Aufbringen der mindestens einen wässrigen Suspension in Schritt b) mittels Tauchen, Pinseln und/oder Sprühauftragung erfolgt. Besonders bevorzugt erfolgt das Aufbringen der mindestens einen wässrigen Suspension in Schritt b) mittels Sprühauftragung. Für die Herstellung von einer oder mehrerer dünner, schnelltrocknender Refraktärmetallcarbid-Schichten, vorzugsweise mit Schichtdicken im Bereich von 20 µm bis 80 µm, ist die Sprühauftragung die bevorzugte Wahl. Dabei kann durch eine schnelle Rotation des Bauteils durch den Sprühstrahl eine sehr dünne Suspensionsschicht auf der Oberfläche aufgebracht werden, die je nach Feststoffgehalt der Suspension schnell bis sehr schnell trocknen kann. Bevorzugt sind dabei Feststoffgehalte des Refraktärmetallcarbid-Pulvers größer gleich 70 Gew.-% von der Gesamtsuspension. Jede aufzutragende Einzellage sollte vorzugsweise ein vergleichbares Trocknungsverhalten zeigen. Grundsätzlich wird ein schnelltrocknendes Verhalten der aufgetragenen Suspensionsschichten bevorzugt, da Dichteunterschiede zwischen Refraktärmetallcarbid und Sinteradditiv zu einer Inhomogenität in der Verteilung der Partikel führen kann, wenn die Schichten zu lange trocknen.

Vorzugsweise kann in Schritt b) mindestens eine Schicht der wässrigen Suspension mit einer mittleren Schichtdicke mindestens 20 µm, bevorzugt von 20 µm bis 150 µm, besonders bevorzugt von 30 µm bis 100 µm, auf der mindestens einen Oberflächenversiegelungsschicht aufgebracht werden.

Eine weitere bevorzugte Variante des erfindungsgemäßen Verfahrens ist dadurch gekennzeichnet, dass der Sinterprozess in Schritt c)
- bei einer Temperatur von 2100 °C bis 2500 °C, bevorzugt von 2200 °C bis 2400 °C, und/oder
- mit einer Haltezeit von 1 h bis 15 h, bevorzugt von 2 h bis 10 h, und/oder
- bei einem Druck von 0,1 bar bis 10 bar, bevorzugt 0,7 bar bis 5 bar, und/oder
- unter Argon-Atmosphäre.
erfolgt.

Durch diese Ausgestaltungen des Sinterprozesses kann einerseits erreicht werden, dass die erhaltene Schutzschicht eine besonders hohe mechanische Stabilität mit einer besonders hohen Abrieb- und Haftfestigkeit aufweist. Zudem wird durch diese Ausgestaltungen des Sinterprozesses die Stabilität der Schmelzphase über den gesamten Sinterprozess erhöht.

Die vorliegende Erfindung betrifft ferner ein beschichtetes Substrat, umfassend ein poröses Substrat, mindestens eine auf mindestens einem Bereich der Oberfläche des porösen Substrats angeordnete Oberflächenversiegelungsschicht und mindestens eine auf der mindestens einen Oberflächenversiegelungsschicht angeordnete Schutzschicht, welche mindestens ein Refraktärmetallcarbid enthält,
wobei das poröse Substrat ein Material enthält oder aus diesem besteht, welches ausgewählt ist aus der Gruppe bestehend aus Graphit, C/SiC-Faserverbundwerkstoffen, SiC/SiC-Faserverbundwerkstoffen, carbidischen Keramiken, nitridischen Keramiken, oxidischen Keramiken, und Mischungen hiervon,
wobei die mindestens eine Oberflächenversiegelungsschicht ausgewählt ist aus der Gruppe bestehend aus pyrolytischen Kohlenstoffschichten, Siliciumschichten, Zirconiumboridschichten, Tantalnitridschichten, Siliciumcarbidschichten, Siliciumnitridschichten und Kombinationen hiervon, und
wobei das beschichtete Substrat mit dem erfindungsgemäßen Verfahren herstellbar oder hergestellt ist.

Aufgrund der mindestens einen Oberflächenversiegelungsschicht kann die mindestens eine Schutzschicht sehr homogen und nur geringfügig rissbehaftet (oder sogar rissfrei) erhalten werden, so dass die mindestens eine Schutzschicht das poröse Substrat besser vor Fremdeinflüssen (wie z.B. vor korrosiven Medien in Hochtemperaturanwendungen) schützen kann.

Durch die mindestens eine Oberflächenversiegelungsschicht können die Poreneingänge (der Poren des porösen Substrats), die sich auf dem mindestens einen Bereich der Oberfläche des porösen Substrats befinden, vollständig oder zumindest nahezu vollständig verschlossen sein.

Eine bevorzugte Ausführungsform des erfindungsgemäßen beschichteten Substrats zeichnet sich dadurch aus, dass die mindestens eine auf der mindestens einen Oberflächenversiegelungsschicht angeordnete Schutzschicht eine mittlere Schichtdicke von mindestens 20 µm, bevorzugt von 20 µm bis 150 µm, besonders bevorzugt von 30 µm bis 100 µm, aufweist.

Gemäß einer weiteren bevorzugten Ausführungsform des erfindungsgemäßen beschichteten Substrats liegt die Standardabweichung der mittleren Schichtdicke der mindestens einen Schutzschicht unter 6 %, bevorzugt im Bereich von 0,5 % bis 6 %, besonders bevorzugt im Bereich von 1 % bis 6 %.

Die Standardabweichung der mittleren Schichtdicke ist ein Maß für die Homogenität (bzw. Gleichmäßigkeit) der Schichtdicke der Schicht. Je geringer die Standardabweichung der mittleren Schichtdicke der mindestens einen Schutzschicht ist, desto homogener (bzw. gleichmäßiger) ist auch die Schichtdicke der mindestens einen Schutzschicht.

Anhand von Querschliffen kann der optische Verlauf der mindestens einen Schutzschicht auf klassische Weise dargestellt und ausgewertet werden. Hierbei kann eine optische Betrachtung des Querschliffs und die qualitative Einordnung in ein homogenes oder inhomogenes Schichtsystem vorgenommen werden.

Die mittlere Schichtdicke der mindestens einen Schutzschicht kann ebenfalls anhand von Querschliffen des beschichteten Substrats bestimmt werden. So wird die mittlere Schichtdicke bestimmt, in dem eine Vielzahl von Punktmessungen an dem Schichtquerschliff durchgeführt werden, woraus dann eine Standardabweichung berechnet werden kann, die zusätzlich eine quantitative Einschätzung über die Homogenität des Schichtverlaufs liefert.

Beispielsweise ist die Quantifizierung der Homogenität über die Standardabweichung der Schichtdicke auf folgende Weise möglich:
- Herstellung eines Querschliffs von beschichtetem Substrat (d.h. Schicht + Substrat)
- Messung der Distanz zwischen Grenzfläche und Schichtoberfläche (Schichtdicke) anhand von aufgenommenen Querschliffsbildern
- Schichtdickenanalyse in einem Bereich mit maximaler Ausdehnung von z.B. 4 cm
- Anzahl der Schichtdicken-Einzelmessungen beträgt mindestens 25 pro 1 cm Messbereich
- Abstand der Schichtdicken-Einzelmessungen ist regelmäßig
- Ermittlung der Standardabweichung über alle Schichtdicken-Einzelmessungen
- Beispielsweise kann bei einer Standardabweichung von ≤ 6 % angenommen werden, dass eine homogene Schicht vorliegt.

Ohne eine aufwändige Querschliffpräparation durchzuführen, kann anhand der Draufsicht schon eine schnelle, qualitative Aussage über die Homogenität der Schicht getroffen werden.

Zudem ist es bevorzugt, dass
- das poröse Substrat iso-Graphit enthält oder aus diesem besteht, und/oder
- das mindestens eine Refraktärmetallcarbid ausgewählt ist aus der Gruppe bestehend aus Titancarbiden, Zirconiumcarbiden, Hafniumcarbiden, Vanadiumcarbiden, Niobcarbiden, Tantalcarbiden, Chromcarbiden, Molybdäncarbiden, Wolframcarbiden, und Mischungen hiervon.

Ganz besonders bevorzugt handelt es sich beim dem mindestens einen Refraktärmetallcarbid um Tantalcarbid.

Das poröse Substrat kann vorzugsweise ein Material enthalten oder aus diesem bestehen, welches ausgewählt ist aus der Gruppe bestehend aus Graphit, bevorzugt iso-Graphit, carbidischen Keramiken, nitridischen Keramiken, oxidischen Keramiken, und Mischungen hiervon.

Das poröse Substrat kann vorzugsweise ein Material enthalten oder aus diesem bestehen, welches ausgewählt ist aus der Gruppe bestehend aus Graphit, bevorzugt iso-Graphit, C/SiC-Faserverbundwerkstoffen, SiC/SiC-Faserverbundwerkstoffen, und Mischungen hiervon.

Ganz besonders bevorzugt enthält das poröse Substrat Graphit, bevorzugt iso-Graphit, oder besteht daraus.

Bei dem porösen Substrat kann es sich vorzugsweise um ein Kohlenstoff-Substrat, besonders bevorzugt um ein Graphit-Substrat, ganz besonders bevorzugt um ein iso-Graphit-Substrat, handeln. Unter iso-Graphit wird dabei Graphit verstanden, der nach dem Verfahren des isostatischen Pressens hergestellt wurde. Beispielsweise kann das poröse Substrat ein Tiegel, vorzugsweise ein Kohlenstoff-Tiegel, besonders bevorzugt ein Graphit-Tiegel, ganz besonders bevorzugt ein iso-Graphit-Tiegel, sein.

Vorzugsweise ist der thermische Ausdehnungskoeffizient (CTE) der mindestens eine Oberflächenversiegelungsschicht an den thermischen Ausdehnungskoeffizienten des porösen Substrats und/oder an den thermischen Ausdehnungskoeffizienten der mindestens einen Schutzschicht angepasst. Auf diese Weise können CTE-Unterschiede zwischen dem porösen Substrat und der mindestens einen Schutzschicht ausgeglichen werden und in Folge die thermischen Spannungen bzw. die Ausprägung der thermisch induzierten Risse noch weiter minimiert werden. In Abhängigkeit des CTE-Unterschieds zwischen der Schutzschicht und dem Substrat kann die Oberflächenversiegelungsschicht dahingehend genutzt werden, um einen großen CTE-Unterschied auszugleichen bzw. diesen zu minimieren - vor allem dann, wenn hohe thermisch induzierte Spannungen dafür sorgen, dass es zu starker Rissbildung oder sogar zur Delamination nach dem Sintern kommt und dadurch die Schutzschichteigenschaften nicht sichergestellt werden.

Zudem ist bevorzugt, dass der thermische Ausdehnungskoeffizient des porösen Substrats kleiner ist als der thermische Ausdehnungskoeffizient der mindestens einen Schutzschicht, wobei der Unterschied zwischen dem thermischen Ausdehnungskoeffizienten des Substrats und dem thermischen Ausdehnungskoeffizienten der mindestens einen Schutzschicht größer ist als 2 e⁻⁶/K oder kleiner ist als 1 e⁻⁶/K.

Ferner betrifft die vorliegende Erfindung auch die Verwendung des erfindungsgemäßen beschichteten Substrats in der Halbleiterkristallzüchtung, wobei es sich bei dem beschichteten Substrat vorzugsweise um einen beschichteten Tiegel handelt.

Die vorliegende Erfindung wird anhand der nachfolgenden Figuren und Beispiele näher erläutert, ohne die Erfindung auf die speziell dargestellten Parameter zu beschränken.

### Ausführungsbeispiel 1

Die Oberfläche eines porösen Graphit-Substrats (mittlerer Porendurchmesser: 1,8 µm, Korngröße: 10 µm, Rₐ: 1,5 µm) wird mit einer Oberflächenversiegelungsschicht versehen, indem die Poren des porösen Substrats mit Silicium infiltriert werden und das Silicium zumindest teilweise in Siliciumcarbid umgewandelt wird. Hierzu werden feine Silicium-Bruchstücke auf die Oberfläche des porösen Graphitsubstrats aufgebracht und anschließend einer Wärmebehandlung bei einer Temperatur von 1500 °C für eine Dauer von 5 h in Vakuum-Atmosphäre unterzogen werden. Bei der auf diese erhaltenen Oberflächenversiegelungsschicht handelt es sich um eine Siliciumcarbidschicht.

Danach wird eine wässrige Suspension schichtförmig auf der erhaltenen Oberflächenversiegelungsschicht aufgebracht, wobei die wässrige Suspension aus 80 Gew.-% TaC-Pulver, 0,1 Gew.-% Tetrabutylammoniumhydroxid, 1 Gew.-% Polyvinylalkohol und 18,9 Gew.-% Wasser besteht. Im Anschluss wird das mit der wässrigen Suspension versehene Substrat einem Sinterprozess unterzogen, welcher bei einer Temperatur von 2300 °C, mit einer Haltezeit von 10 h und bei einem Druck von 1 bar erfolgt.

Auf diese Weise wird ein beschichtetes Graphit-Substrat erhalten, das ein poröses Graphit-Substrat, eine auf dem porösen Graphit-Substrat angeordnete Siliciumcarbid-Oberflächenversiegelungsschicht und eine auf der Siliciumcarbid-Oberflächenversiegelungsschicht angeordnete TaC-Schutzschicht umfasst.

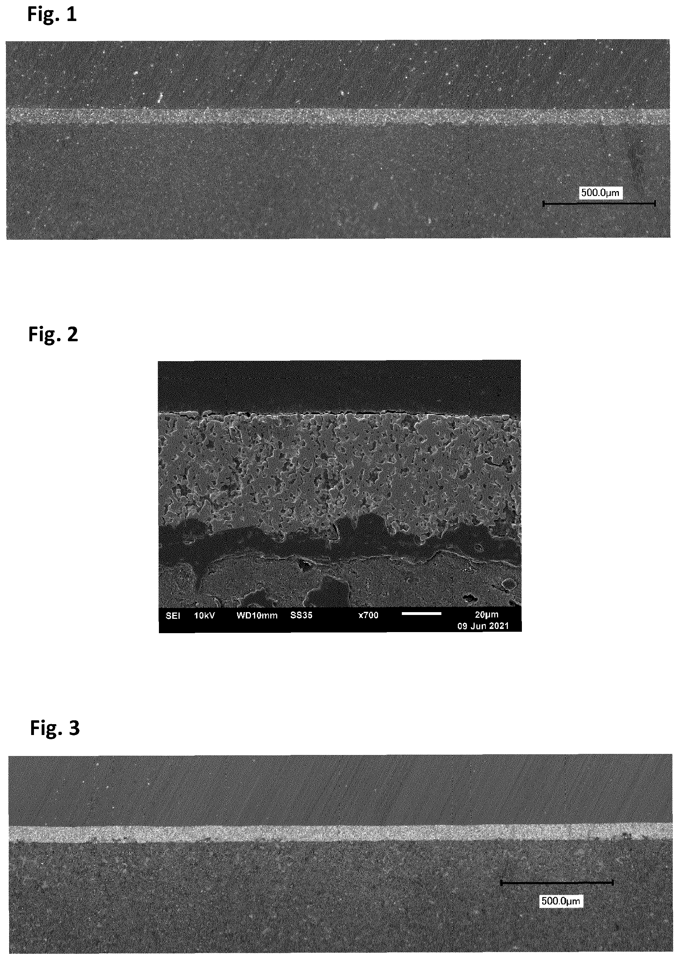

Zur Untersuchung des beschichteten Substrats wird ein Querschliff des beschichteten Substrats hergestellt. Ein Bild dieses Querschliffs ist in Fig. 1 dargestellt. Zudem zeigt Fig. 2 eine REM-Aufnahme des Querschliffs.

Anhand des Querschliffs werden die mittlere Schichtdicke der TaC-Schicht sowie die Standardabweichung der mittleren Schichtdicke bestimmt. Hierfür werden an mindestens 25 Messstellen pro 1 cm Messbereich der Schicht Schichtdicken-Einzelmessungen vorgenommen, indem die Distanz zwischen Grenzfläche und Schichtoberfläche (Schichtdicke) anhand von aufgenommenen Querschliffsbildern gemessen wird, wobei die Abstände zwischen den einzelnen Messstellen regelmäßig sind. Auf diese Weise wird für die mittlere Schichtdicke der TaC-Schicht ein Wert von 64,8 µm bestimmt. Zudem wird eine Standardabweichung über alle Schichtdicken-Einzelmessungen von 3,3 µm (5,1 %) ermittelt.

Da die Standardabweichung nicht mehr als 6 % beträgt, handelt es sich bei der TaC-Schicht somit um eine homogene Schicht.

### Ausführungsbeispiel 2

Die Oberfläche eines porösen Graphit-Substrats (mittlerer Porendurchmesser: 1,8 µm, Korngröße: 10 µm, Rₐ: 1,5 µm) wird mit einer Oberflächenversiegelungsschicht versehen, indem die Poren des porösen Substrats mit Silicium infiltriert werden und das Silicium zumindest teilweise in Siliciumcarbid umgewandelt wird. Hierzu wird grobes Silicium-Pulver auf die Oberfläche des porösen Graphitsubstrats aufgebracht und anschließend einer Wärmebehandlung bei einer Temperatur von 1500 °C für eine Dauer von 5 h in VakuumAtmosphäre unterzogen wird. Bei der auf diese erhaltenen Oberflächenversiegelungsschicht handelt es sich um eine Siliciumcarbidschicht.

Danach wird eine wässrige Suspension schichtförmig auf der erhaltenen Oberflächenversiegelungsschicht aufgebracht, wobei die wässrige Suspension aus 80 Gew.-% TaC-Pulver, 0,1 Gew.-% Tetrabutylammoniumhydroxid, 1 Gew.-% Polyvinylalkohol und 18,9 Gew.-% Wasser besteht. Im Anschluss wird das mit der wässrigen Suspension versehene Substrat einem Sinterprozess unterzogen, welcher bei einer Temperatur von 2300 °C, mit einer Haltezeit von 10 h und bei einem Druck von 1 bar erfolgt.

Auf diese Weise wird ein beschichtetes Graphit-Substrat erhalten, das ein poröses Graphit-Substrat, eine auf dem porösen Graphit-Substrat angeordnete Siliciumcarbid-Oberflächenversiegelungsschicht und eine auf der Siliciumcarbid-Oberflächenversiegelungsschicht angeordnete TaC-Schutzschicht umfasst.

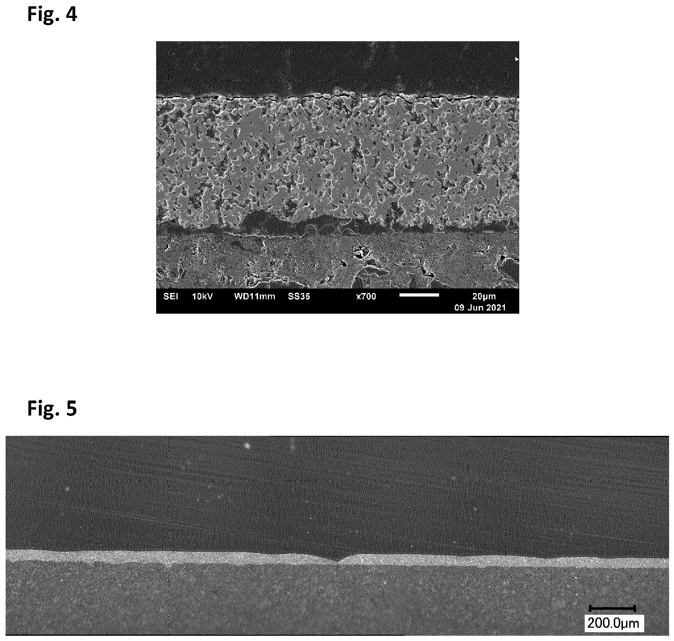

Zur Untersuchung des beschichteten Substrats wird ein Querschliff des beschichteten Substrats hergestellt. Ein Bild dieses Querschliffs ist in Fig. 3 dargestellt. Zudem zeigt Fig. 4 eine REM-Aufnahme des Querschliffs.

Anhand des Querschliffs werden die mittlere Schichtdicke der TaC-Schicht sowie die Standardabweichung der mittleren Schichtdicke bestimmt. Hierfür werden an mindestens 25 Messstellen pro 1 cm Messbereich der Schicht Schichtdicken-Einzelmessungen vorgenommen, indem die Distanz zwischen Grenzfläche und Schichtoberfläche (Schichtdicke) anhand von aufgenommenen Querschliffsbildern gemessen wird, wobei die Abstände zwischen den einzelnen Messstellen regelmäßig sind. Auf diese Weise wird für die mittlere Schichtdicke der TaC-Schicht ein Wert von 75,3 µm bestimmt. Zudem wird eine Standardabweichung über alle Schichtdicken-Einzelmessungen von 3,5 µm (4,7 %) ermittelt.

Da die Standardabweichung nicht mehr als 6 % beträgt, handelt es sich bei der TaC-Schicht somit um eine homogene Schicht.

### Vergleichsbeispiel

Eine wässrige Suspension wird schichtförmig auf ein poröses Graphit-Substrat (mittlerer Porendurchmesser: 1,8 µm, Korngröße: 10 µm, Rₐ: 1,5 µm), welches keine Oberflächenversiegelungsschicht aufweist, aufgebracht, wobei die wässrige Suspension aus 80 Gew.-% TaC-Pulver, 0,1 Gew.-% Tetrabutylammoniumhydroxid, 1 Gew.-% Polyvinylalkohol und 18,9 Gew.-% Wasser besteht. Im Anschluss wird das mit der wässrigen Suspension versehene Substrat einem Sinterprozess unterzogen, welcher bei einer Temperatur von 2300 °C, mit einer Haltezeit von 10 h und bei einem Druck von 1 bar erfolgt.

Auf diese Weise wird ein beschichtetes Graphit-Substrat erhalten, das ein poröses Graphit-Substrat sowie eine auf dem porösen Graphit-Substrat angeordnete TaC-Schutzschicht aber keine zwischen Substrat und Schutzschicht angeordnete Oberflächenversiegelungsschicht umfasst.

Zur Untersuchung des beschichteten Substrats wird ein Querschliff des beschichteten Substrats hergestellt. Ein Bild dieses Querschliffs ist in Fig. 5 dargestellt.

Anhand des Querschliffs werden die mittlere Schichtdicke der TaC-Schicht sowie die Standardabweichung der mittleren Schichtdicke bestimmt. Hierfür werden an mindestens 25 Messstellen pro 1 cm Messbereich der Schicht Schichtdicken-Einzelmessungen vorgenommen, indem die Distanz zwischen Grenzfläche und Schichtoberfläche (Schichtdicke) anhand von aufgenommenen Querschliffsbildern gemessen wird, wobei die Abstände zwischen den einzelnen Messstellen regelmäßig sind. Auf diese Weise wird für die mittlere Schichtdicke der TaC-Schicht ein Wert von 44,7 µm bestimmt. Zudem wird eine Standardabweichung über alle Schichtdicken-Einzelmessungen von 5,3 µm (11,8 %) ermittelt.

Da die Standardabweichung mehr als 6 % beträgt, handelt es sich bei der TaC-Schicht somit um eine inhomogene Schicht.

## Patentansprüche

1. Verfahren zur Herstellung von beschichteten Substraten, bei welchem
a) mindestens ein Bereich einer Oberfläche eines porösen Substrats mit mindestens einer Oberflächenversiegelungsschicht versehen wird,
b) mindestens eine wässrige Suspension auf der mindestens einen Oberflächenversiegelungsschicht aufgebracht wird, wobei die mindestens eine wässrige Suspension mindestens ein Refraktärmetallcarbid und Wasser enthält, und
c) das Substrat nach Schritt b) einem Sinterprozess unterzogen wird, wobei das poröse Substrat ein Material enthält oder aus diesem besteht, welches ausgewählt ist aus der Gruppe bestehend aus Graphit, C/SiC-Faserverbundwerkstoffen, SiC/SiC-Faserverbundwerkstoffen, carbidischen Keramiken, nitridischen Keramiken, oxidischen Keramiken, und Mischungen hiervon, und
wobei die mindestens eine Oberflächenversiegelungsschicht ausgewählt ist aus der Gruppe bestehend aus pyrolytischen Kohlenstoffschichten, Siliciumschichten, Zirconiumboridschichten, Tantalnitridschichten, Siliciumcarbidschichten, Siliciumnitridschichten und Kombinationen hiervon.

2. Verfahren nach dem vorhergehenden Anspruch, **dadurch gekennzeichnet, dass**
- das poröse Substrat iso-Graphit enthält oder aus diesem besteht, und/oder
- das mindestens eine Refraktärmetallcarbid ausgewählt ist aus der Gruppe bestehend aus Titancarbiden, Zirconiumcarbiden, Hafniumcarbiden, Vanadiumcarbiden, Niobcarbiden, Tantalcarbiden, Chromcarbiden, Molybdäncarbiden, Wolframcarbiden, und Mischungen hiervon.

3. Verfahren nach einem der vorhergehenden Ansprüche, **dadurch gekennzeichnet, dass** das mindestens eine Refraktärmetallcarbid in der mindestens einen wässrigen Suspension partikulär vorliegt, wobei die mittlere Partikelgröße (d50-Wert) der Partikel des mindestens einen Refraktärmetallcarbids im Bereich von 0,2 µm bis 2 µm, bevorzugt von 0,5 µm bis 1,5 µm, liegt.

4. Verfahren nach einem der vorhergehenden Ansprüche, **dadurch gekennzeichnet, dass** das poröse Substrat in Schritt a) mit mindestens einer Oberflächenversiegelungsschicht versehen wird, indem
- zumindest ein Teil der Oberfläche des porösen Substrats mit mindestens einem polymerisierbaren Harz imprägniert wird und das Harz anschließend carbonisiert wird, und/oder
- zumindest ein Teil der Oberfläche des porösen Substrats mit mindestens einem Polysilan imprägniert wird und das Polysilan anschließend pyrolysiert wird, und/oder
- die Poren des porösen Substrats mit Silicium infiltriert werden und das Silicium zumindest teilweise in Siliciumcarbid umgewandelt wird, und/oder
- mindestens eine Schicht ausgewählt aus der Gruppe bestehend aus Schichten aus pyrolytischem Kohlenstoff, Siliciumcarbidschichten, Siliciumnitridschichten, und Kombinationen hiervon mittels CVD auf dem porösen Substrat abgeschieden wird, und/oder
- mindestens eine Schicht ausgewählt aus der Gruppe bestehend aus Siliciumschichten, Zirconiumboridschichten, Tantalnitridschichten und Kombinationen hiervon mittels eines Sprühprozesses auf dem porösen Substrat abgeschieden wird.

5. Verfahren nach einem der vorhergehenden Ansprüche, **dadurch gekennzeichnet, dass** die mindestens eine wässrige Suspension
- 60 bis 90 Gew.-%, bevorzugt 70 bis 85 Gew.-%, des mindestens einen Refraktärmetallcarbids, bezogen auf das Gesamtgewicht der wässrigen Suspension, enthält, und/oder
- 0,01 bis 0,5 Gew.-% mindestens eines Dispergierungsmittel, bezogen auf das Gesamtgewicht der wässrigen Suspension, enthält, wobei das Dispergierungsmittel vorzugsweise ausgewählt ist aus der Gruppe bestehend aus Ammoniumhydroxid, Polyalkylenglycolether und Mischungen hiervon, und/oder
- 0,01 bis 5 Gew.-% mindestens eines Bindemittels, bezogen auf das Gesamtgewicht der wässrigen Suspension, enthält, wobei das Bindemittel vorzugsweise ausgewählt ist aus der Gruppe bestehend aus Polyvinylalkohol, Polyphenyloxid und Mischungen hiervon, und/oder
- durch Vermischen ihrer Komponenten mithilfe eines Dispergiergeräts hergestellt wird, wobei das Vermischen mithilfe des Dispergiergeräts vorzugsweise unter Verwendung von Mahlkörpern und/oder über einen Zeitraum von mindestens 12 Stunden erfolgt.

6. Verfahren nach einem der vorhergehenden Ansprüche, **dadurch gekennzeichnet, dass** das Aufbringen der mindestens einen wässrigen Suspension in Schritt b) mittels Tauchen, Pinseln und/oder Sprühauftragung, vorzugsweise mittels Sprühauftragung, erfolgt.

7. Verfahren nach einem der vorhergehenden Ansprüche, **dadurch gekennzeichnet, dass** der Sinterprozess in Schritt c)
- bei einer Temperatur von 2100 °C bis 2500 °C, bevorzugt von 2200 °C bis 2400 °C, und/oder
- mit einer Haltezeit von 1 h bis 15 h, bevorzugt von 2 h bis 10 h, und/oder
- bei einem Druck von 0,1 bar bis 10 bar, bevorzugt 0,7 bar bis 5 bar, und/oder
- unter Argon-Atmosphäre.
erfolgt.

8. Beschichtetes Substrat, umfassend ein poröses Substrat, mindestens eine auf mindestens einem Bereich der Oberfläche des porösen Substrats angeordnete Oberflächenversiegelungsschicht und mindestens eine auf der mindestens einen Oberflächenversiegelungsschicht angeordnete Schutzschicht, welche mindestens ein Refraktärmetallcarbid enthält
wobei das poröse Substrat ein Material enthält oder aus diesem besteht, welches ausgewählt ist aus der Gruppe bestehend aus Graphit, C/SiC-Faserverbundwerkstoffen, SiC/SiC-Faserverbundwerkstoffen, carbidischen Keramiken, nitridischen Keramiken, oxidischen Keramiken, und Mischungen hiervon,
wobei die mindestens eine Oberflächenversiegelungsschicht ausgewählt ist aus der Gruppe bestehend aus pyrolytischen Kohlenstoffschichten, Siliciumschichten, Zirconiumboridschichten, Tantalnitridschichten, Siliciumcarbidschichten, Siliciumnitridschichten und Kombinationen hiervon, und
wobei das beschichtete Substrat mit einem Verfahren gemäß einem der Ansprüche 1 bis 7 herstellbar oder hergestellt ist.

9. Beschichtetes Substrat nach Anspruch 8, **dadurch gekennzeichnet, dass** die mindestens eine Schutzschicht eine mittlere Schichtdicke von mindestens 20 µm, bevorzugt von 20 µm bis 150 µm, besonders bevorzugt von 30 µm bis 100 µm, aufweist.

10. Beschichtetes Substrat nach Anspruch 8 oder 9, **dadurch gekennzeichnet, dass** die Standardabweichung der mittleren Schichtdicke der mindestens einen Schutzschicht unter 6 %, bevorzugt im Bereich von 0,5 % bis 6 %, besonders bevorzugt im Bereich von 1 % bis 6 %, liegt.

11. Verwendung eines beschichteten Substrats nach einem der Ansprüche 8 bis 10 in der Halbleiterkristallzüchtung, wobei es sich bei dem beschichteten Substrat vorzugsweise um einen beschichteten Tiegel handelt.

## Claims

1. A method of producing coated substrates in which method
a) at least one region of a surface of a porous substrate is provided with at least one surface sealing layer;
b) at least one aqueous suspension is applied to the at least one surface sealing layer, with the at least one aqueous suspension comprising at least one refractory metal carbide and water; and
c) the substrate is subjected to a sintering process after step b),
wherein the porous substrate comprises or consists of a material that is selected from the group consisting of graphite, C/SiC fiber composite materials, SiC/SiC fiber composite materials, carbidic ceramics, nitridic ceramics, oxidic ceramics, and mixtures thereof, and
wherein the at least one surface sealing layer is selected from the group consisting of pyrolytic carbon layers, silicon layers, zirconium boride layers, tantalum nitride layers, silicon carbide layers, silicon nitride layers, and combinations thereof.

2. A method in accordance with the preceding claim, **characterized in that**
- the porous substrate comprises or consists iso-graphite; and/or
- the at least one refractory metal carbide is selected from the group consisting of titanium carbides, zirconium carbides, hafnium carbides, vanadium carbides, niobium carbides, tantalum carbides, chromium carbides, molybdenum carbides, tungsten carbides, and mixtures thereof.

3. A method in accordance with one of the preceding claims, **characterized in that** the at least one refractory metal carbide is present in the at least one aqueous suspension in particle form, with the mean particle size (d50 value) of the particles of the at least one refractory metal carbide being in the range from 0.2 µm to 2 µm, preferably from 0.5 µm to 1.5 µm.

4. A method in accordance with one of the preceding claims, **characterized in that** the porous substrate is provided with at least one surface sealing layer in step a) by
- impregnating at least a portion of the surface of the porous substrate with at least one polymerizable resin and subsequently carbonizing the resin; and/or
- impregnating at least a portion of the surface of the porous substrate with at least one polysilane and subsequently pyrolyzing the polysilane; and/or
- infiltrating the pores of the porous substrate with silicon and converting the silicon at least partly into silicon carbide; and/or
- at least one layer selected from the group consisting of layers of pyrolytic carbon, silicon carbide layers, silicon nitride layers, and combinations thereof is deposited on the porous substrate by means of CVD; and/or
- at least one layer selected from the group consisting of silicon layers, zirconium boride layers, tantalum nitride layers, and combinations thereof is deposited on the porous substrate by means of a spray process.

5. A method in accordance with one of the preceding claims, **characterized in that** the at least one aqueous suspension
- comprises 60 to 90 wt%, preferably 70 to 85 wt%, of the at least one refractory metal carbide, relative to the total weight of the aqueous suspension; and/or
- comprises 0.01 to 0.5 wt% of a dispersion agent relative to the total weight of the aqueous suspension, with the dispersion agent preferably being selected from the group consisting of polyvinyl alcohols; polyacrylic acids; polyvinylpyrrolidones; polyalkylene gly-colethers; bases, preferably tetrabutylammonium hydroxide, tetramethylammonium hydroxide, polyethyleneimines, inorganic bases, in particular NaOH, ammonium hydroxide; and mixtures thereof, more preferably selected from the group consisting of ammonium hydroxide, polyalkelene glycolether, and mixtures thereof; and/or
- comprises 0.01 to 5 wt% of a binding agent relative to the total weight of the aqueous suspension, with the binding agent preferably being selected from the group consisting of polyethylene glycol, polyvinyl butyral, polyurethanes, chloroprene rubber, phenolic resins, acrylic resins, carboxymethyl celluloses, alginic acid, dextrins, sodium biphenyl-2-yloxides, polyphenyloxide, and mixtures thereof, more preferably selected from the group consisting of sodium biphenyl-2-yloxides, polyphenyl oxide, and mixtures thereof; and/or
- is manufactured by mixing its components with the aid of a dispersion device, with the mixing preferably taking place with the aid of the dispersion device while using grinding elements and/or over a time period of at least 12 hours.

6. A method in accordance with one of the preceding claims, **characterized in that** the application of the at least one aqueous suspension takes place by means of dipping, brushing, and/or spray application, preferably by means of spray application, in step b).

7. A method in accordance with one of the preceding claims, **characterized in that** the sintering process in step c) takes place
- at a temperature of from 2100°C to 2500°C, preferably from 2200°C to 2400°C, and/or
- with a holding time of 1 hour to 15 hours, preferably of 2 hours to 10 hours, and/or
- at a pressure of 0.1 bar to 10 bar, preferably 0.7 bar to 5 bar, and/or
- under argon atmosphere.

8. A coated substrate comprising a porous substrate, at least one surface sealing layer arranged on at least one region of the surface of the porous substrate, and at least one protective layer that is arranged on the at least one surface sealing layer and that comprises at least one refractory metal carbide,
wherein the porous substrate comprises or consists of a material that is selected from the group consisting of graphite, C/SiC fiber composite materials, SiC/SiC fiber composite materials, carbidic ceramics, nitridic ceramics, oxidic ceramics, and mixtures thereof,
wherein the at least one surface sealing layer is selected from the group consisting of pyrolytic carbon layers, silicon layers, zirconium boride layers, tantalum nitride layers, silicon carbide layers, silicon nitride layers, and combinations thereof, and
wherein the coated substrate can be or is manufactured by a method in accordance with one of the claims 1 to 7.

9. A coated substrate in accordance with claim 8, **characterized in that** the at least one protective has a mean layer thickness of at least 20 µm, preferably of 20 µm to 150 µm, particularly preferably of 30 µm to 100 µm.

10. A coated substrate in accordance with claim 8 or claim 9, **characterized in that** the standard deviation of the mean layer thickness of the at least one protective layer is below 6%, preferably in the range of 0.5% to 6% particularly preferably in the range of 1% to 6%,.

11. Use of a coated substrate in accordance with one of the claims 8 to 10 in semiconductor crystal growing, with the coated substrate preferably being a coated crucible.

## Revendications

1. Procédé pour la fabrication de substrats revêtus, dans lequel
a) au moins une zone d'une surface d'un substrat poreux est munie d'au moins une couche de scellement de surface,
b) au moins une suspension aqueuse est appliquée sur l'au moins une couche de scellement de surface, dans lequel l'au moins une suspension aqueuse contient au moins un carbure métallique réfractaire et de l'eau et
c) le substrat est soumis, après l'étape b), à un processus de frittage,
dans lequel le substrat poreux contient un matériau ou est constitué d'un matériau poreux qui est sélectionné dans le groupe constitué du graphite, de matériaux composites à fibres C/SiC, de matériaux composites à fibres SiC/SiC, de céramiques à base de carbures, de céramiques à base de nitrures, de céramiques à base d'oxydes et de mélanges de ceux-ci et
dans lequel l'au moins une couche de scellement de surface est sélectionné dans le groupe constitué de couches de carbone pyrolytique, de couches de silicium, de couches de borure de zirconium, de couches de nitrure de tantale, de couches de carbure de silicium, de couches de nitrure de silicium et de combinaisons de celles-ci.

2. Procédé selon l'une des revendications précédentes, **caractérisé en ce que**
- le substrat poreux contient de l'iso-graphite ou est constitué de celui-ci et/ou
- l'au moins un carbure métallique réfractaire est sélectionné dans le groupe constitué de carbures de titane, de carbures de zirconium, de carbures d'hafnium, de carbures de vanadium, de carbures de niobium, de carbures de tantale, de carbures de chrome, de carbures de molybdène, de carbures de tungstène et de mélanges de ceux-ci.

3. Procédé selon l'une des revendications précédentes, **caractérisé en ce que** l'au moins un carbure métallique réfractaire est présent sous forme particulaire dans l'au moins une suspension aqueuse, dans lequel la taille de particule moyenne (valeur d50) des particules de l'au moins un carbure métallique réfractaire est de l'ordre de 0,2 µm à 2 µm, de préférence de 0,5 µm à 1,5 µm.

4. Procédé selon l'une des revendications précédentes, **caractérisé en ce que** le substrat poreux est muni, dans l'étape a), d'au moins une couche de scellement de surface, grâce au fait que
- au moins une partie de la surface du substrat poreux est imprégné d'au moins une résine polymérisable et la résine est ensuite carbonisée et/ou
- au moins une partie de la surface du substrat poreux est imprégné d'au moins un polysilane et le polysilane est ensuite pyrolysé et/ou
- les pores du substrat poreux sont infiltrés avec du silicium et le silicium est ensuite transformé au moins partiellement en carbure de silicium et/ou
- au moins une couche sélectionnée dans le groupe constitué de couches de carbone pyrolytique, de couches de carbure de silicium, de couches de nitrure de silicium et de combinaisons de celles-ci, est déposée par CVD sur le substrat poreux et/ou
- au moins une couche sélectionnée dans le groupe constitué de couches de silicium, de couches de borure de zirconium, de couches de nitrure de tantale et de combinaisons de celles-ci, est déposée par pulvérisation sur le substrat poreux.

5. Procédé selon l'une des revendications précédentes, **caractérisé en ce que** l'au moins une suspension aqueuse
- contient de 60 à 90 % en poids, de préférence de 70 à 85 % en poids, de l'au moins un carbure métallique réfractaire, par rapport au poids total de la suspension aqueuse et/ou
- contient de 0,01 à 0,5 % en poids d'au moins un agent de dispersion, par rapport au poids total de la suspension aqueuse, dans lequel l'agent de dispersion est de préférence sélectionné dans le groupe constitué de l'hydroxyde d'ammonium, de polyalkylèneglucoléther et de mélanges de ceux-ci et/ou
- contient de 0,01 à 5 % en poids d'au moins un liant, par rapport au poids total de la suspension aqueuse, dans lequel le liant est de préférence sélectionné dans le groupe constitué de l'alcool polyvinylique, du polyphényloxyde et de mélanges de ceux-ci, et/ou
- est réalisée par le mélange de ses composants au moyen d'un appareil de dispersion, dans lequel le mélange a lieu à l'aide de l'appareil de dispersion de préférence en utilisant des billes de broyage et/ou pendant une période d'au moins 12 heures.

6. Procédé selon l'une des revendications précédentes, **caractérisé en ce que** l'application de l'au moins une suspension aqueuse à l'étape b) a lieu par immersion, application par pinceaux et/ou pulvérisation, de préférence par pulvérisation.

7. Procédé selon l'une des revendications précédentes, **caractérisé en ce que** le processus de frittage à l'étape c) a lieu :
- à une température de 2100 °C à 2500 °C, de préférence de 2200 °C à 2400 °C et/ou
- avec un temps de maintien de 1 h à 15 h, de préférence de 2 h à 10 h et/ou
- à une pression de 0,1 bar à 10 bar, de préférence de 0,7 bar à 5 bar et/ou
- sous une atmosphère d'argon.

8. Substrat revêtu, comprenant un substrat poreux, au moins une couche de scellement de surface disposée sur au moins une zone de la surface du substrat poreux et au moins une couche protectrice disposée sur l'au moins une couche de scellement de surface, qui contient au moins un carbure métallique réfractaire,
dans lequel le substrat poreux contient ou est constitué d'un matériau qui est sélectionné dans le groupe constitué du graphite, de matériaux composites à fibres C/SiC, de matériaux composites à fibres SiC/SiC, de céramiques à base de carbures, de céramiques à base de nitrures, de céramiques à base d'oxydes et de mélanges de ceux-ci,
dans lequel l'au moins une couche de scellement de surface est sélectionné dans le groupe constitué de couches de carbone pyrolytique, de couches de silicium, de couches de borure de zirconium, de couches de nitrure de tantale, de couches de carbure de silicium, de couches de nitrure de silicium et de combinaisons de celles-ci et
dans lequel le substrat revêtu eut être réalisé ou est réalisé avec un procédé selon l'une des revendications 1 à 7.

9. Substrat revêtu selon la revendication 8, **caractérisé en ce que** l'au moins une couche protectrice présente une épaisseur de couche moyenne d'au moins 20 µm, de préférence de 20 µm à 150 µm, plus particulièrement de préférence de 30 µm à 100 µm.

10. Substrat revêtu selon la revendication 8 ou 9, **caractérisé en ce que** l'écart standard de l'épaisseur de couche moyenne de l'au moins une couche protectrice et inférieur à 6 %, de préférence de 0,5% à 6 %, plus particulièrement de 1 % à 6 %.

11. Utilisation d'un substrat revêtu selon l'une des revendications 8 à 10 dans la croissance cristalline de semi-conducteurs, dans lequel le substrat revêtu est de préférence un creuset revêtu.
